# EUROPEAN PATENT APPLICATION

(11) **EP 1 367 719 A2**
(43) Date of publication of application: **03.12.2003**
(21) Application number: 03003650.3
(22) Date of filing: 18.02.2003
(51) Int. Cl.: H03M 1/14, H03M 1/36

(54) **AD converter circuit and AD conversion method**

(30) Priority: 30.05.2002 JP 2002157190
(71) Applicant: FUJITSU LIMITED, Kawasaki-shi, Kanagawa 211-8588 (JP)
(72) Inventor: Ito, Shogo, Kasugai-shi, Aichi 487-0013 (JP); Suzuki, Hisao, Kasugai-shi, Aichi 487-0013 (JP)
(74) Representative: Seeger, Wolfgang, Dipl.-Phys.

(57) **Abstract**

This invention provides an AD converter circuit and an AD conversion method capable of executing AD conversion up to the lowest bit properly even under a high-speed operation. The AD converter circuit 1 comprises high-order-comparators D1-D3, low-order comparator D0 and a comparison reference voltage source 10 having seven reference voltage output points V1-V3, Va-Vd. The reference voltage output points V1-V3 are connected to the reference voltage terminals of the high-order-comparators D1-D3. The reference voltage output points Va-Vd are connected to a point A having parasitic capacitance through analog switches SWA-SWD. The point A is connected to the reference voltage terminal of the low-order comparator D0 through an analog switch SW2 and an input voltage VIN through an analog switch SWE.

## Description

This application is based upon and claims the benefit of priority from each of the prior Japanese Patent Application No. 2002-157190 filed on May 30, 2002, the entire contents of which are incorporated herein by reference.

The present invention relates to an AD converter circuit which receives an input of analog signal and outputs digital signal corresponding to that signal and an AD conversion method thereof, and more particularly to an AD converter circuit which supplies a reference voltage to a comparator for low-order bits corresponding to determination about high-order-bits so as to determine the low-order bits and an AD conversion method thereof.

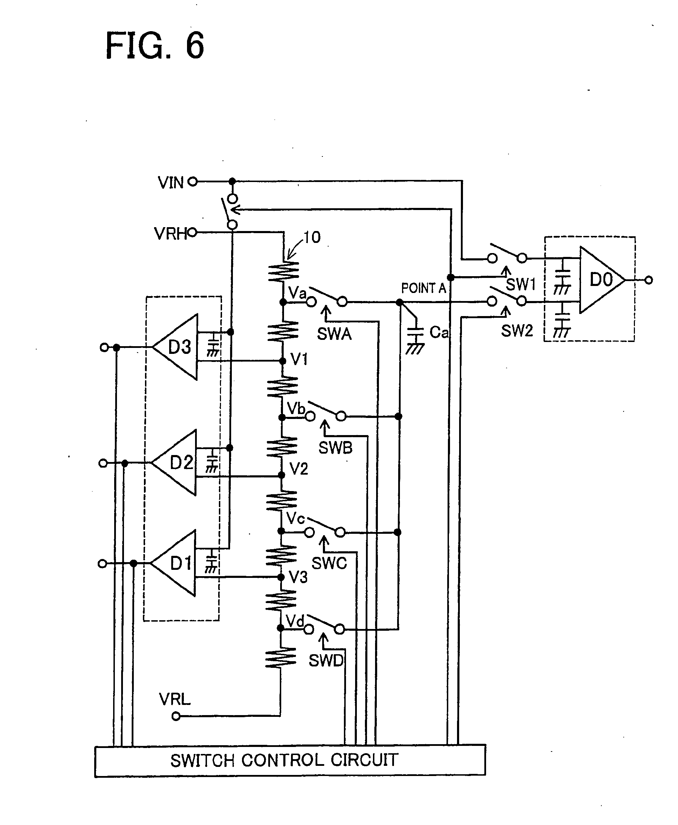

Fig. 6 shows an example of the AD converter circuit used conventionally for converting analog signal to digital signal. The AD converter circuit shown in Fig. 6 is called serial-parallel circuit, which includes a low level comparator D0 for low-order bits and high level comparators D1-D3 for high-order-bits. It further includes a reference voltage source 10 containing plural resistors connected in series. AD conversion with this AD converter circuit is performed as follows. First, high-order-bits are determined by the high level comparators D1 D3. In the meantime, any one of the analog switches SWA-SWD is closed depending on the result of conversion of a previous cycle. Then, after the high-order-bits are determined, another switch of the analog switches SWA-SWD is closed additionally according to that determination. If the newly selected switch is different from the switch closed up to then, that switch closed to then is opened. Consequently, any one of the reference voltages Va-Vd is supplied to the low level comparator D0 via a point A in Fig. 6 depending on the value of a high-order-bit and the low-order bits are determined by the low level comparator D0.

The AD conversion with the aforementioned conventional AD converter circuit has following problems. That is, it converts the low-order bits erroneously at the time of high-speed operation. The reason is parasitic capacitance which is contained unavoidably in the circuit. Particularly because a number of the analog switches are connected to the point A in Fig. 6, the sum of the parasitic capacitances Ca is considerably large. Thus, the waveform of a voltage change at the point A becomes dull.

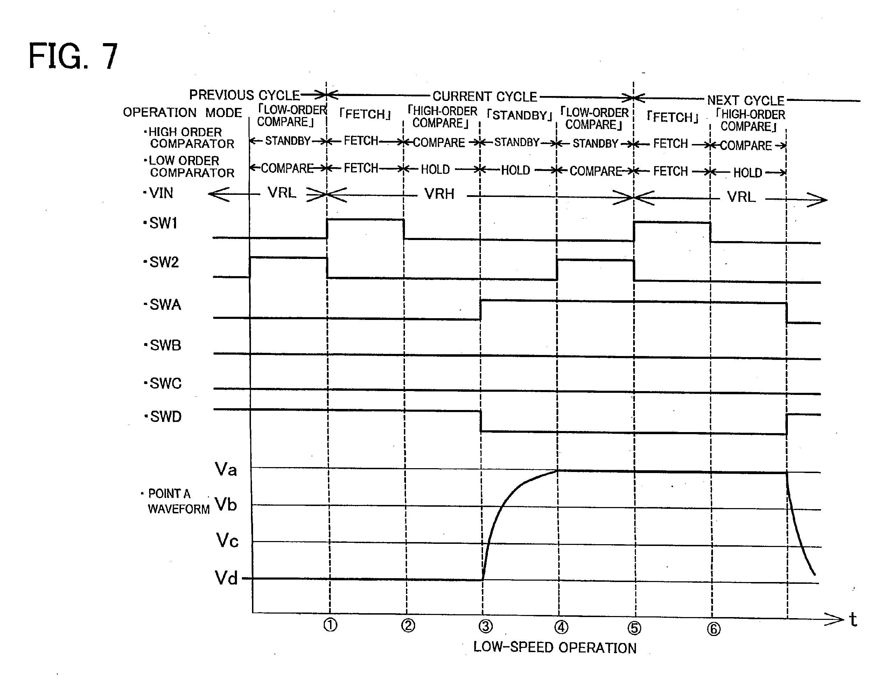

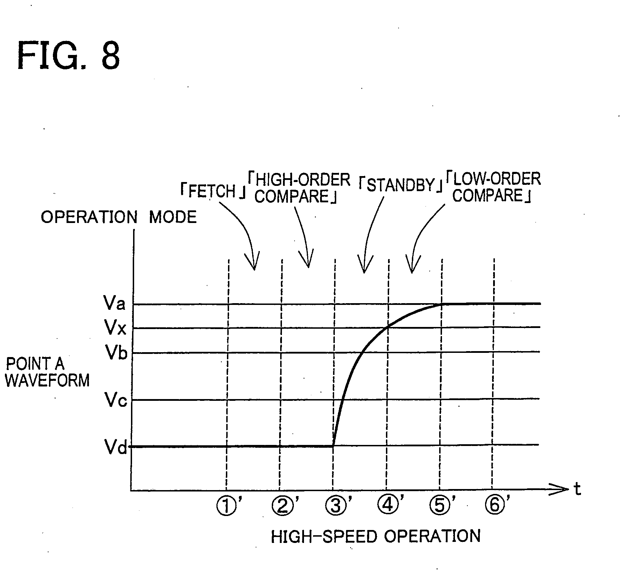

This will be described with reference to timing chart shown in Fig. 7. As shown in the timing chart of Fig. 7, the operation of this AD converter circuit is repetition of four steps including "fetch" (①-②), "high-order compare" (②-③) , "stand-by" (③-④), and "low-order compare" (④-⑤) . Fig. 7 shows a case where although the input voltage VIN is the same as low-voltage-side power source voltage VRL of the reference voltage source 10 in a previous cycle, it is equal to high-voltage-side power source voltage VRH of the reference voltage source 10. In this case, after the timing (③), the voltage at the point A rises from a voltage Vd to a voltage Va. This rise width is equivalent to 3/4 a potential difference between the voltage VRL and the voltage VRH. However, the voltage at the point A does not change so rapidly for the above-described reason. Thus, the procedure cannot be proceeded to "low-order compare" step until a predetermined time elapses so that the voltage at the point A is settled to a voltage Va. That is, the operation of Fig. 7 is a quite low-speed operation taking into account this predetermined time. Therefore, under a high-speed operation as shown in Fig. 8, the step of "low-order compare" begins before the voltage at the point A is settled to the voltage Va (timing ④'). For this reason, the low-order comparator D0 happens to compare in a condition that the reference voltage is changing from Vx to Va. Consequently, an erroneous conversion occurs in low-order bits. In the meantime, the time for each operation mode in the high-speed operation of Fig. 8 is shorter than the case of low-speed operation of Fig. 7.

The present invention has been achieved to solve the aforementioned problems with the conventional AD converter circuit. Therefore, an object of the present invention is to provide an AD converter circuit capable of executing AD conversion even under a high-speed operation and an AD conversion method thereof.

To achieve the above-described object, according to one aspect of the present invention, there is provided an AD converter circuit comprising: an input voltage terminal; a comparison reference voltage source having plural reference voltage output points; a high-order-bit comparator for determining digital value of high-order-bit by comparing voltage at references voltage output points spaced at an interval of the comparison reference voltage source with voltage of the input voltage terminal; a low-order comparator for determining digital value of low-order bit by comparing the voltage of remaining reference voltage output points of the comparison reference voltage source with voltage of the input voltage terminal; a reference voltage input line for inputting reference voltage into reference voltage terminal of the low-order-bit comparator; a first-switch-element group for switching opening/closing between reference voltage output points of the comparison reference voltage source other than the one connected to the high-order-bit comparator and the reference voltage input line; and a second switch element for switching opening/closing between the input voltage terminal and the reference voltage input line.

The AD converter circuit according to one aspect of the present invention can achieve the AD conversion method comprising: separating the reference voltage input line from all the reference voltage output points of the comparison reference voltage source and fetching input voltage into the reference voltage input line; separating the reference voltage input line from input voltage and making the high-order-bit comparator to determine the high-order-bit; connecting the reference voltage input line to a reference voltage output point of the comparison reference voltage source other than the reference voltage output points connected to the high-order-bit comparator and corresponding to the result of determination of the high-order-bit; and making the low-order-bit comparator to determine the low-order bit.

For that purpose, the switch elements of the first-switch-element group are all opened while the second switch element is closed so as to fetch the voltage of the input voltage terminal into the reference voltage input line and after opening the second switch element, the high-order-comparator is made to determine high-order-bit. A switch device corresponding to the result of determination of the high-order-bit of the first-switch-element group is closed and the voltage of a corresponding reference voltage output point of the comparison reference voltage source is applied to the reference voltage input line and after that, the low-order bit is determined. Consequently, the input voltage is applied to the reference voltage input line by the time when the high-order-bit is determined. The input voltage is close to a voltage which should be inputted to the low-order-bit comparator as the comparison reference voltage when the low-order bit is determined. Thus, the width of change in voltage when the voltage is switched to the comparison reference voltage corresponding to the result of determination of the high-order-bit is small. Therefore, the voltage of the reference voltage input line is soon settled to the comparison reference voltage. Consequently, a proper AD conversion is enabled without any error of conversion in the low-order bit even under a high-speed operation.

That is, the low-order bit is determined after a predetermined time necessary for the voltage in the reference voltage input line to be settled elapses after a switch device corresponding to the result of determination of the high-order-bit of the first-switch-element group is closed. Because, according to the present invention, the voltage of the reference voltage input line is set near an object voltage preliminarily, that predetermined time can be shorter. Thus, the high-speed operation is achieved.

As evident from the above description, the present invention enables to provide an AD converter circuit and an AD conversion method capable of achieving AD conversion up to the lowest bit even under the high-speed operation.

The above and further objects and novel features of the invention will more fully appear from the following detailed description when the same is read in connection with the accompanying drawings. It is to be expressly understood, however, that the drawings are for the purpose of illustration only and are not intended as a definition of the limits of the invention.
Fig. 1 is a circuit block diagram showing the structure of an AD converter circuit of a first embodiment;
Fig. 2 is a timing chart showing the operation of the AD converter circuit according to the first embodiment;
Fig. 3 is a chart showing the operation function of the first embodiment;
Fig. 4 is a circuit block diagram showing the structure of the AD converter circuit according to the second embodiment;
Fig. 5 is a chart showing the operation function of the second embodiment;
Fig. 6 is a circuit block diagram showing the structure of a conventional AD converter circuit;
Fig. 7 is a timing chart showing the operation! of the conventional AD converter circuit; and
Fig. 8 is a timing chart in case where the conventional AD converter circuit operates at high speeds.

### [First embodiment]

Hereinafter, the first embodiment of the present invention will be described in detail with reference to the accompanying drawings. This embodiment concerns 3-bit serial-parallel type AD converter circuit having three high-order-comparators and a low-order comparator.

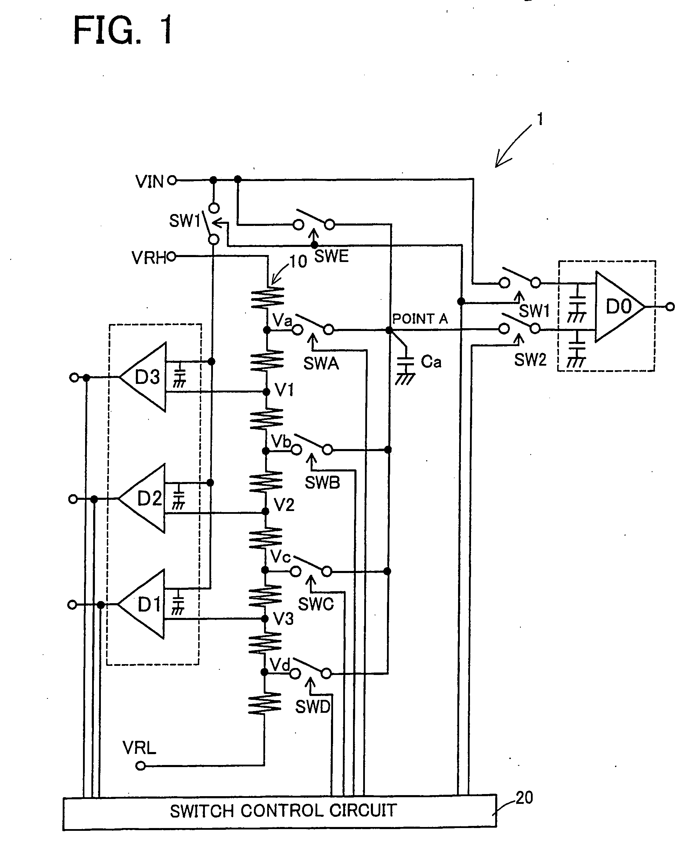

As shown in Fig. 1, an AD converter circuit 1 comprises high-order-comparators D1-D3 including three comparators and a low-order comparator D0. Further, it possesses a comparison reference voltage source 10 including eight resistors each having an equal resistance value connected in series. The comparison reference voltage source 10 is provided with seven reference voltage output points Va-Vd, V1-V3. These reference voltage output points Va-Vd, V1-V3 are disposed in the order of Va, V1, Vb, V2, Vc, V3, Vd from the high voltage side VRH of the comparison reference voltage source 10. The comparison voltage terminal of each high-order-comparator D1-D3 is connected to an input voltage terminal VIN through one of analog switches SW1. The reference voltage terminal of each high-order-comparator D1-D3 is connected to each of the reference voltage output points V3, V2, V1. That is, the reference voltage output point to which the reference voltage terminal of each of the high-order-comparators D1-D3 is connected serves as the reference voltage output points of the comparison reference voltage source 10, spaced at an interval. Analog switches SWA-SWD are connected to remaining reference voltage output points Va-Vd of the comparison reference voltage source 10.

The other terminal end of each of the analog switches SWA-SWD is connected to the point A in Fig. 1. The point A is connected to the reference voltage terminal of the low-order comparator D0 through the analog switch SW2 and possesses a parasitic capacitance Ca. Further, the point A is connected to the input voltage terminal VIN through the analog switch SWE. The comparison voltage terminal of the low-order comparator D0 is connected to the input voltage terminal VIN through one of analog switches SW1. Here, a circuit portion around the point A connected to the reference voltage terminal of the low-order comparator D0 through the analog switch SW2 corresponds to a reference voltage input line.

The AD converter circuit 1 has a switch control circuit 20. The switch control circuit 20 receives inputs of comparison results of the high-order-comparators D1-D3 and controls opening and closing of all the analog switches SWA-SWE, SW1, SW2 . The same control signal is outputted to the analog switch SWE and the analog switches SW1. Therefore, the analog switch SWE and the analog switches SW1 carry out the same opening/closing operation under control by the switch control circuit 20. Here, the analog switches SWA-SWD correspond to the first switch group while the analog switch SWE corresponds to the second switch element and the analog switches SW1 corresponds to the third switch element.

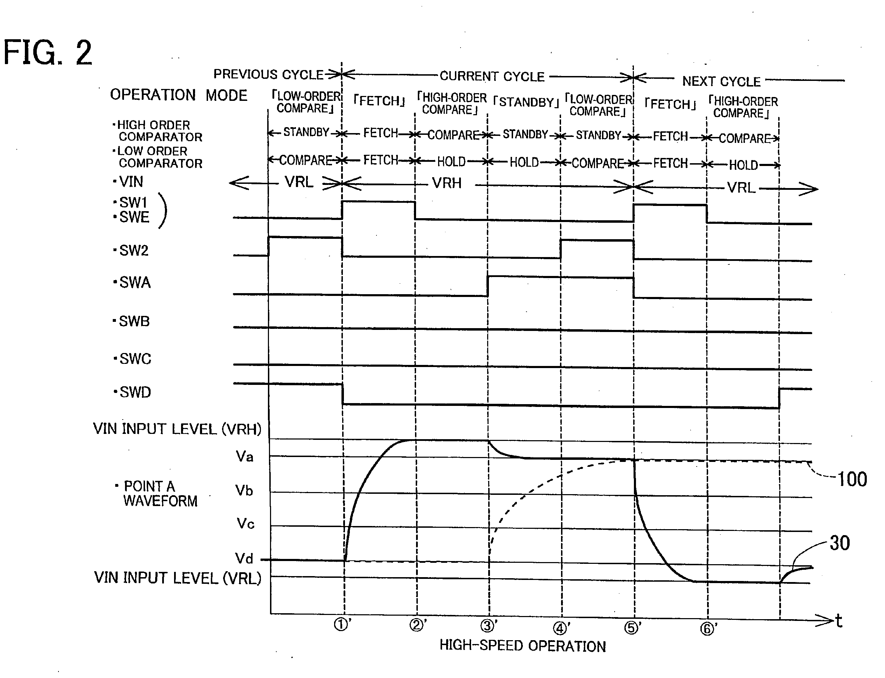

Next, the operation of the AD converter circuit 1 will be described with reference to the timing chart of Fig. 2. As shown in the timing chart of Fig. 2, the operation of the AD converter circuit 1 is repetition of four steps including "fetch" (①' -②' ) , "high-order comparison" (②' - ③' ), "stand-by" (③'-④'), and "low-order comparison" (④' -⑤' ). This point is the same as a conventional example. Like Fig. 7, Fig. 2 indicates that the input voltage VIN of a previous cycle is equal to the low-voltage-side power source voltage VRL of the reference voltage source 10 while the input voltage VIN of this cycle is equal to the high-voltage-side power source voltage VRH of the reference voltage source 10. On the other hand, Fig. 2 is different 'from the operation timing of Fig. 7, indicating an enlargement of the same high-speed operation as Fig. 8 in a lateral direction. Therefore, the time of each operation mode is shorter than the case of low-speed operation of Fig. 7. A dotted line 100 in Fig. 2 indicates the voltage waveform at the point A when the conventional AD converter circuit is operated. This is the same as the voltage waveform at the point A shown in Fig. 7. The dotted line 100 has not yet been settled to the voltage Va properly at the timing ④' of starting the "low-order compare". On the other hand, a solid line 30 indicates the voltage waveform at the point A in the AD conversion circuit 1 of this embodiment.

The control method for the switches in each step and the operation of the circuit thereby will be described in succession. First, in step of "fetch", the analog switches SW1, SWE are closed. The other analog switches SW2, SWA-SWD are all open. Therefore, the input voltage VIN is applied to the compare voltage terminals of the high-order-comparators D1-D3 and the comparison voltage terminal of the low-order comparator D0 through one of analog switches SW1. Consequently, the input voltage VIN can be fetched into the comparison voltage terminal of each of the comparators D0-D3. Further, the input voltage VIN is applied to the point A through the analog switch SWE. As a result, the input voltage VIN is fetched into the point A and at timing ②', the potential level at the point A nears the input voltage VIN (VRH here) . Then, at timing ②' , the analog switches SW1, SWE are opened. Thus, the comparison voltage terminal of each of the comparators D0-D3 and the point A hold the potential level at this timing. Then, the reference voltages V1-V3 are always applied to the reference voltage terminals of the high-order-comparators D1-D3.

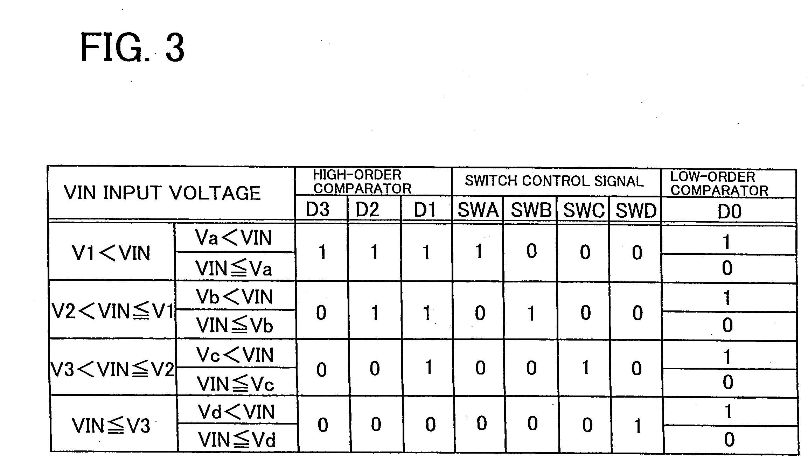

Next, in the process of "high-order compare", all the analog switches are opened. The high-order-comparators D1-D3 compare the input voltage VIN with each of the reference voltages V1-V3 and outputs its result to the switch control circuit 20. As indicated on the column of "high-order-comparator" of Fig. 3, if V1<VIN, all the high-order-comparators D1-D3 output "1". If V2<VIN≤V1 the high-order-comparators D1, D2 output "1" while the high-order-comparator D3 outputs "0". Further, if V3<VIN≤V2, the high-order-comparator D1 outputs "1"' while the high-order-comparators D2, D3 output "0". If VIN≤V3, all the high-order-comparators D1-D3 output "0". That is, which range the input voltage VIN belongs to of the above-described four ranges is determined based on the comparison result of the high-order-comparators D1-D3. Consequently, high-order two bits are determined.

Next, the switch control circuit 20 determines the opening/closing of the analog switches SWA-SWD in the subsequent "stand-by" process following the comparison result of the high-order-comparators D1-D3. The relationship between the range of the input voltage VIN and the opening/closing of each switch, clarified from the comparison result of the high-order-comparators D1-D3, is indicated on the column "VIN input voltage" and "switch control signal" of Fig. 3. "1" in the column "switch control signal" of Fig. 3 means that the switch is closed while "0" means that that switch is opened. That is, in case of V1<VIN, it is determined that the analog switch SWA is closed. In case of V2<VIN≤V1, it is determined that the analog switch SWB is closed. In case of V3<VIN≤V2 it is determined that the analog switch SWC is closed. In case of VIN≤V3, it is determined that the analog switch SWD is closed. In any case, all remaining analog switches are kept open. In this cycle, because the input voltage VIN is equal to the high-voltage-side power source voltage VRH, Va<VIN occurs so that the analog switch SWA is closed.

Next, in the process of "stand-by", one of the analog switches, SWA-SWD is closed based on the result of the "high-order comparison" process. Consequently, any one of the voltages Va-Vd is applied to the point A. Which range the input voltage VIN belongs to of four ranges sectioned by the respective reference voltages V1-V3 is determined in the "high-order comparison" process. The reference voltage (one of Va-Vd applied to the point A are near the input voltage VIN because it is an intermediate voltage of the range containing the input voltage VIN. On the other hand, because the potential level at the point A in the previous "fetch" process is near the input voltage VIN, the potential difference relative to the currently applied reference voltages Va-Vd is small. Thus, the potential at the point A reaches the level of the reference voltages Va-Vd in a relatively short time. Therefore, at timing ④' in which the "stand-by" process terminates, the voltage is settled to the level of the reference voltages Va-Vd securely. Because the analog switch SWA is closed in this cycle, the voltage Va is applied to the point A.

Depending on such condition as a difference in the input voltage VIN between a previous cycle and a current cycle, the value of the parasitic capacitance Ca at the point A, the potential level at the point A does not always reach the input voltage VIN by the timing ② of the "fetch" process. However, at least that potential level approaches the input voltage VIN. Further, because the potential level is separated from the input voltage VIN after the "fetch" process, it is not affected if the input voltage VIN changes after that. Therefore, the width of change in the voltage in the "stand-by" process is so small, that at timing ④' , the potential level is capable of being settled to the level of the reference voltages Va-Vd securely.

Next, in "low-order comparison", the analog switch SW2 as well as the analog switch SWA is closed. Consequently, the potential at the point A is fetched to the reference voltage terminal of the low-order comparator D0 in a short time. The reason is that the parasitic capacitance of the reference voltage terminal of the low-order comparator D0 is very small compared with parasitic capacitance Ca at the point A. Therefore, the reference voltage terminal of the low-order comparator D0 reaches the level of the reference voltages Va-Vd immediately. On the other hand, the input voltage VIN in the "fetch" process is fetched into the comparison voltage terminal of the low-order comparator D0. Then, the low-order comparator D0 compares the potentials at both terminals and outputs its result. Because the comparison voltage terminal of the low-order comparator D0 is separated from the circuit after the "fetch" process, it is not affected even if the input voltage VIN changes after that. Therefore, the low-order comparator D0 holds the input voltage VIN at timing ②' , so that it is capable of comparing with the reference voltages Va-Vd.

As indicated at the column "VIN input voltage" and the column "low-order comparator" of Fig. 3, the low-order comparator D0 outputs "1" if the reference voltage (one of Va-Vd)<VIN, and outputs "0" if VIN≤reference voltage (one of Va-Vd). Because the voltage Va is applied to the point A in this cycle, the reference voltage terminal of the low-order comparator D0 is at the reference voltage Va. Because the input voltage VIN is VRH, Va<VIN occurs and the low-order comparator D0 outputs "1". Consequently, the low-order bits are determined. Consequently, it comes that three bits are determined corresponding to the high-order-bits determined by the "high-order compare" process. Then, this cycle is terminated.

Because in the AD converter circuit 1 of this embodiment, the analog switches SW1 are closed in the "fetch" process as described above in detail, the input voltage VIN is fetched into the comparison voltage terminals of the high-order-comparators D1-D3 and the low-order comparator D0. At this time, all the analog switches SWA-SWD are opened and the analog switch SWE is closed. Thus, the input voltage VIN is fetched into nodes near the point A, which serves as a reference voltage input line of the low-order comparator D0. In the "high-order compare" process, all the analog switches SWA-SWE, SW1 are opened and the high-order-comparators D1-D3 compare . In the "stand-by" process, if the one corresponding to a determination result of the high-order-comparators D1-D3 of the analog switches SWA-SWD is closed, the reference voltage for the low-order bits is fetched into the point A. Because a voltage near the previously fetched input voltage VIN is selected as this reference voltage, the width of change in voltage at this time is small. Therefore, the potential at the point A is settled to the reference voltage in a short time. In the "low-order compare" process, the low-order comparator D0 is capable of comparing the input voltage VIN with a proper reference voltage. Consequently, even at the high-speed operation, the AD converter circuit 1 can carry out AD conversion properly up to the lowest bit.

The opening/closing operation of the analog switch SWE for opening/closing a connection between the point A and the input voltage terminal VIN is equal to that of the analog switches SW1 for fetching the input voltage VIN into each of the comparators D0-D3. Therefore, these analog switches SWE, SW1 can be operated under the same operation signal. Thus, this embodiment can be carried out easily without changing the switch control circuit 20.

### [Second embodiment]

Next, the second embodiment of the present invention will be described in detail with reference to the accompanying drawings. In the AD converter circuit 2 of this embodiment, the low-order comparator D0 of this AD converter circuit 1 is comprised of three comparators so as to carry out AD conversion for four bits.

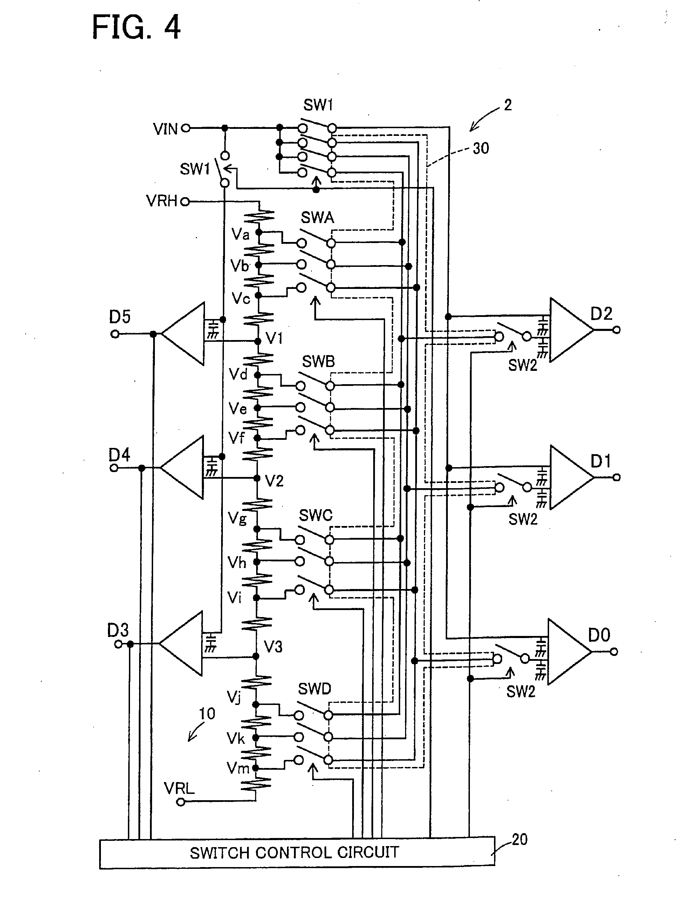

As shown in Fig. 4, the AD converter circuit 2 includes high-order-comparators D3-D5 and low-order comparators D0-D2, the high- and low-order comparators being each comprised of three comparators. Further, it containsaswitchcontrol circuit 20, which is the same as the switch control circuit 20 of the AD converter circuit 1 of the first embodiment. In the comparison reference voltage source 10 of the AD converter circuit 2, 16 resistors each having the same resistance are connected in series.

As shown in Fig. 4, the comparison reference voltage source 10 of the AD converter circuit 2 includes 15 reference voltage output points Va-Vm, V1-V3. These reference voltage output points Va-Vm, V1-V3 are disposed in the order of Va, Vb, Vc, V1, Vd, Ve, Vf, V2, Vg, Vh, Vi, V3, Vj, Vk, Vm from the side of the high voltage VRH of the comparison reference voltage source 10. The comparison voltage terminal of each of the high-order-comparators D3-D5 is connected to the input voltage terminal VIN through one of analog switches SW1. The reference voltage terminals of the high-order-comparators D3-D5 are connected to the reference voltage output points V3, V2, V1. Analog switches are connected to remaining reference voltage output points Va-Vm of the comparison reference voltage source 10.

The analog switches connected to the reference voltage output points Va-Vm are gathered to three groups, constituting analog switch groups SWA-SWD. That is, three analog switches connected to the reference voltage output points Va-Vc constitute analog switch group SWA. Three analog switches connected to the reference voltage output points Vd-Vf constitute analog switch group SWB. Three analog switches connected to the reference voltage output points Vg-Vi constitute analog switch group SWC. Further, three analog switches connected to the reference voltage output points Vj-Vm constitute analog switch group SWD.

The other end of analog switches which are connected to the highest voltage among each analog switch groups SWA-SWD are connected to the reference voltage terminal of the low-order comparator D2 through one of analog switches SW2. Further, the ones which are to the intermediate voltage are connected to the reference voltage terminal of the low-order comparator D1 through one of analog switches SW2. The ones which are to the lowest voltage are connected to the reference voltage terminal of the low-order comparator D0 through one of analog switches SW2. That is, the reference voltage output points Va, Vd, Vg, Vj can be connected to the low-order comparator D2, the reference voltage output points Vb, Ve, Vh, Vk to the low-order comparator D1, and the reference voltage output points Vc, Vf, Vi, Vm to the low-order comparator D0.

The reference voltage terminal of each of the low-order comparators D0-D2 is connected to the input voltage terminal VIN through an analog switch in the analog switch group SW1. The comparison voltage terminals of the low-order comparators D0-D2 are connected to the input voltage terminal VIN through an analog switch in the analog switch group SW1. In such a circuit configuration, three reference voltage input lines corresponding to the point A of the AD converter circuit 1 exist in a circuit portion 30 enclosed with dotted line in Fig. 4. Of course, they contain parasitic capacitances. The switch control circuit 20 outputs each equal signal to plural analog switches contained in the analog switch groups SWA-SWD, SW1, SW2, respectively.

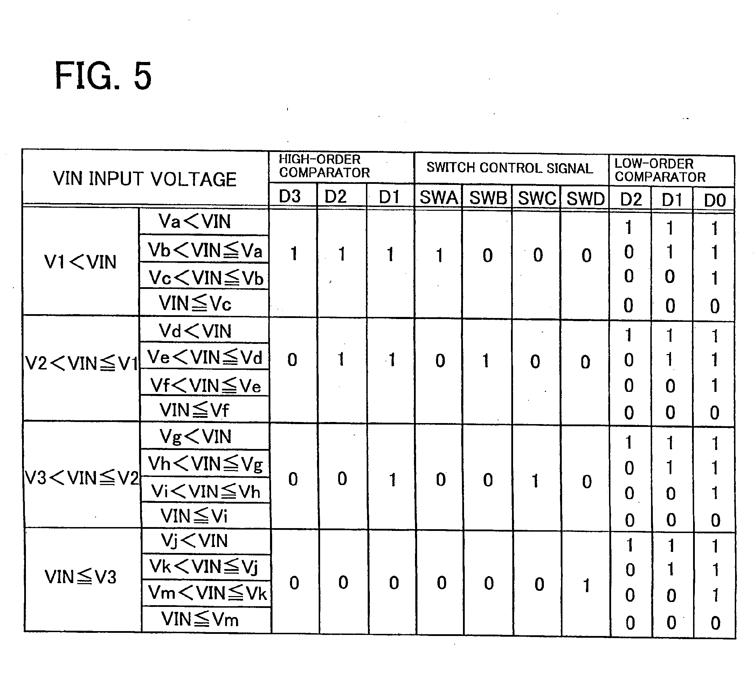

The operation of this AD converter circuit 2 is substantially the same as that of the AD converter circuit 1. That is, in the "fetch" process, the analog switches SW1 are closed while other analog switch groups SWA-SWD, SW2 are opened. Consequently, the input voltage VIN is fetched into the comparison voltage terminals of the low-order comparators D0-D2, the comparison voltage terminals of the high-order-comparators D3-D5 and the three reference voltage input lines in a circuit portion 30. Next, in the "high-order compare" process, all the analog switches are opened and the high-order-comparators D3-D5 compare. Next, in the "stand-by" process, the analog switches SWA-SWD are closed depending on the comparison result of the high-order-comparators D3-D5 so as to fetch the reference voltage into the circuit portion 30. The relation between the comparison result of the high-order-comparators D3-D5 and the control method for the respective analog switch groups SWA-SWD is the same as the case of the AD converter circuit 1 as indicated in the operation table of Fig. 5. Then, in the "low-order compare" process, the analog switches SW2 are closed and the low-order comparators D0-D2 perform comparison.

For example, suppose that, like in Fig. 2, the input voltage VIN is VRL in a previous cycle and VRH in this cycle. Consequently, VRH is applied to each node in the circuit portion 30 in the "fetch" process, so that its potential turns to substantially VRH. In the "stand-by" process, the analog switches SWA ares closed. Consequently, the reference voltage Va is applied to wiring leading to the low-order comparator D2, the reference voltage Vb is applied to wiring leading to the low-level comparator D1 and the reference voltage Vc is applied to wiring leading to the low-level comparator D0. Differences between these three kinds of the voltages are not so large, but near the input voltage VIN. Therefore, during the "stand-by" process, each wiring is settled to that applied voltage. Then, when the analog switches SW2 are closed in the "low-level compare" process, each reference voltage Va-Vc is fetched into the reference voltage terminal of each of the low-level comparators D0-D2 in a very short time. Thus, the low-level comparators D0-D2 can compare the input voltage VIN of that comparison voltage terminal with each reference voltage Va-Vc.

As shown in the operation table of Fig. 5, this AD converter circuit 2 determines higher two bits as a result of comparison by the high-order-comparators D3-D5. Then, lower two bits are determined from the result of comparison by the low-order comparators D0-D2. As a result, the input voltage VIN is sectioned to 16 stages, thereby enabling 4-bit AD conversion. As the number of the low-level comparators for low-order bit is increased, the accuracy of the voltage value of the reference voltage terminal becomes more important. The AD conversion circuit 2 can bring the reference voltage terminal of each of the low-level comparators D0-D2 to each accurate reference voltage.

As described above in detail, the AD converter circuit of this . embodiment can execute AD conversion up to the lowest bit accurately even under a high speed operation, as well as AD converter circuit 1.

In the meantime, this embodiment is only an exemplification and does not restrict the present invention. Therefore, needless to say, the present invention may be improved or modified within a range not departing from a gist thereof.

For the example, according to the above-mentioned first embodiment, the present invention is embodied in a 3-bit AD converter circuit for high-order two bits and low-order one bit. Further, according to the second embodiment, the present invention is embodied in a 4-bit AD converter circuit for high- and low-order two bits. However, the bit numbers of the high-order and low-order are not restricted to these examples but the present invention may be embodied in an AD converter circuit for other bit number.

Further, the AD converter circuit may be constructed with three stages, namely, high-order, middle-order and low-order. Further, the AD converter circuit may be constructed with more stages.

As a switch group to be controlled by the switch control circuit, it is permissible to employ other kind of switch such as a MOS switch or the like instead of the analog switch.

## Claims

1. An AD converter circuit comprising:
an input voltage terminal;
a comparison reference voltage source having plural reference voltage output points;
a high-order-bit comparator for determining digital value of high-order-bit by comparing voltage at reference voltage output points spaced at an interval of the comparison reference voltage source with voltage of the input voltage terminal;
a low-order comparator for determining digital value of low-order bit by comparing the voltage of remaining reference voltage output points of the comparison reference voltage source with voltage of the input voltage terminal;
a reference voltage input line for inputting reference voltage into reference voltage terminal of the low-order-bit comparator;
a first-switch-element group for switching opening/closing between reference voltage output points of the comparison reference voltage source other than the one connected to the high-order-bit comparator and the reference voltage input line; and
a second switch element for switching opening/closing between the input voltage terminal and the reference voltage input line.

2. The AD converter circuit as claimed in claim 1 further comprising a switch control section for controlling the first-switch-element group and the second switch element, wherein
the switch control section
opens all of the first-switch-element group and closes the second switch element so as to fetch the voltage of the input voltage terminal into the reference voltage input line;
after opening the second switch element, makes the high-order-bit comparator to determine high-order-bit;
closes a switch device corresponding to the result of determination of the high-order-bit of the first-switch-element group and applies voltage of a corresponding reference voltage output point of the comparison reference voltage source to the reference voltage input line; and
after that, makes the low-order-bit comparator to determine low-order bit.

3. The AD converter circuit as claimed in claim 2 further comprising
a third switch element which switches opening/closing between the input voltage terminal and comparison voltage terminals of the high-order-bit comparator and of the low-order-bit comparator and is under control of the switch control section and
the switch control section makes the second switch element and the third switch element to execute the same operation.

4. The AD converter circuit as claimed in claim 2 wherein the switch control section, after a predetermined time elapses after a switch device corresponding to the result of determination of high-order-bit of the first-switch-element group is closed, makes the low-order-bit comparator to determine the low-order bit.

5. The AD converter circuit as claimed in claim 3 wherein the switch control section, after a predetermined time elapses after a switch device corresponding to the result of determination of high-order-bit of the first-switch-element group is closed, makes the low-order-bit comparator to determine the low-order bit.

6. An AD conversion method of an AD converter circuit comprising: a comparison reference voltage source having plural reference voltage output points; a high-order-bit comparator for determining digital value of high-order-bit by comparing voltage at reference voltage output points spaced at an interval of the comparison reference voltage source with input voltage; a low-order comparator for determining the digital value of low-order bit by comparing voltage of remaining reference voltage output points of the comparison reference voltage source with input voltage; and a reference voltage input line for inputting reference voltage into reference voltage terminal of the low-order-bit comparator, the AD conversion method comprising:
separating the reference voltage input line from all the reference voltage output points of the comparison reference voltage source and fetching input voltage into the reference voltage input line;
separating the reference voltage input line from input voltage and making the high-order-bit comparator to determine the high-order-bit;
connecting the reference voltage input line to a reference voltage output point of the comparison reference voltage source other than the reference voltage output points connected to the high-order-bit comparator and corresponding to the result of determination of the high-order-bit; and
making the low-order-bit comparator to determine the low-order bit.

7. The AD conversion method as claimed in claim 6 wherein when input voltage is fetched into the reference voltage input line, input voltage is fetched into comparison voltage terminals of the high-order-bit comparator and the low-order-bit comparator; and
when the reference voltage input line is separated from input voltage, comparison voltage terminals of the high-order-bit comparator and the low-order-bit comparator are separated from the input voltage terminal.

8. The AD conversion method as claimed in claim 6 wherein the AD converter circuit comprises a first-switch-element group for switching opening/closing between a reference voltage output point of the comparison reference voltage source other than the one connected to the high-order-bit comparator and the reference voltage input line; and a second switch element for switching opening/closing between input voltage and the reference voltage input line,
the AD conversion method further comprising:
opening all of the first-switch-element group while closing the second switch element so as to fetch input voltage into the reference voltage input line;
after opening the second switch element, determining high-order-bit;
closing a switch element corresponding to the result of determination of the high-order-bit of the first-switch-element group and applying voltage of a corresponding reference voltage output point of the comparison reference voltage source to the reference voltage input line; and
after that, determining low-order bit by means of the low-order-bit comparator.

9. The AD conversion method as claimed in claim 8 wherein the AD converter circuit comprises a third switch element for switching opening/closing between input voltage and comparison voltage terminals of the high-order-bit comparator and of the low-order-bit comparator
the AD conversion method making the second switch element and the third switch element to execute the same operation.

10. The AD conversion method as claimed in claim 8, further comprising, after a predetermined time elapses after a switch device corresponding to the result of determination of high-order-bit of the first-switch-element group is closed, determining low-order bit.

11. The AD conversion method as claimed in claim 9, further comprising, after a predetermined time elapses after a switch device corresponding to the result of determination of high-order-bit of the first-switch-element group is closed, determining low-order bit.
